**Europäisches Patentamt**

**European Patent Office**

**Office européen des brevets**

(19)

(11) Veröffentlichungsnummer: **0 464 911 A2**

## (12) EUROPÄISCHE PATENTANMELDUNG

(21) Anmeldenummer: **91201586.4**

(22) Anmeldetag: **20.06.91**

(51) Int. Cl.5: **H04B 17/00, G01R 29/08**

(30) Priorität: **29.06.90 DE 4020694**

(43) Veröffentlichungstag der Anmeldung:
**08.01.92 Patentblatt 92/02**

(84) Benannte Vertragsstaaten:
**DE ES FR GB IT**

(71) Anmelder: **Philips Patentverwaltung GmbH
Wendenstrasse 35 Postfach 10 51 49
W-2000 Hamburg 1(DE)**

(84) **DE**

Anmelder: **N.V. Philips' Gloeilampenfabrieken
Groenewoudseweg 1
NL-5621 BA Eindhoven(NL)**

(84) **ES FR GB IT**

(72) Erfinder: **Schöffel, Peter, Dr.
Baumäcker 11
W-8551 Kirchrüsselbach(DE)**

(74) Vertreter: **Volmer, Georg et al
Philips Patentverwaltung GmbH
Wendenstrasse 35, Postfach 10 51 49
W-2000 Hamburg 1(DE)**

(54) **Funkempfänger mit akustischem Signal.**

(57) 2.1. Bei bekannten Funkempfängern wird bei Unterschreitung einer bestimmten Empfangsfeldstärke ein Signalton über einen Lautsprecher abgestrahlt.

2.2. Um einen Benutzer durch dieses akustische Signal so wenig wie möglich zu beeinträchtigen wird vorgeschlagen, als akustisches Signal ein Rauschsignal zu verwenden.

EP 0 464 911 A2

Die Erfindung betrifft einen Funkempfänger mit einer Anordnung zur Erzeugung eines akustischen Signals.

Aus GB 2 178 270 A ist beispielsweise ein Funkempfänger bekannt, bei dem die Empfangsfeldstärke eines Funkempfangssignals gemessen wird und mit einem Referenzwert verglichen wird. Unterschreitet die gemessene Empfangsfeldstärke den Referenzwert, so wird ein Signalton über einen Lautsprecher abgestrahlt. Durch diesen Signalton gewarnt kann der Benutzer des Funkempfängers solange seinen Standort ändern, bis der Signalton abgeschaltet wird. Für einen ungestörten Empfang ist dann wieder eine ausreichende Empfangsfeldstärke vorhanden.

Aufgabe der vorliegenden Erfindung ist es, bei einem Funkempfänger der eingangs genannten Art eine möglichst geringe Beeinträchtigung des Benutzers durch das akustische Signal zu erreichen und die Funktion eines solchen Funkempfängers zu verbessern.

Diese Aufgabe wird bei einem gattungsgemäßen Funkempfänger dadurch gelöst, daß das akustische Signal ein Rauschsignal ist, das in Abhängigkeit von einer ermittelten Empfangsgüte erzeugt wird.

Überraschenderweise hat sich gezeigt, daß ein Rauschsignal von einem Benutzer als Warnsignal für sinkende Empfangsfeldstärken subjektiv günstiger empfunden wird als ein monofrequentes Tonsignal. Bei einem Rauschsignal, das sich aus Tonfrequenzen unterschiedlichster Frequenz zusammensetzt, werden alle Frequenzen eines wiedergegebenen Sprachsignals breitbandig überlagert. Im Gegensatz zu einem monofrequenten Tonsignal, dessen Leistung bezogen auf das Frequenzbandsystem des Tonsignals relativ hoch ist und daher dieses bestimmte Frequenzband akustisch "zudeckt", verteilt sich die Leistung des Rauschsignals breitbandig über alle Frequenzen. Bei gleicher Leistung des Rauschsignals und des Tonsignals stört das Rauschsignal die Sprachverständlichkeit des empfangenen Signals weniger.

Bei digitalen Empfängerkonzepten, bei denen das Sprachsignal als digitalisierte Datenworte eventuell mit entsprechenden Fehlerschutzmaßnahmen übertragen wird, tritt das Phänomen auf, daß bei Unterschreiten einer bestimmten Empfangsfeldstärke ein wiedergegebenes Sprachsignal ohne vorherige merkliche Verschlechterung abrupt ausbleibt. Bei digitalen Funkempfängern bietet daher die Erfindung darüber hinaus den Vorteil, daß Personen, die im Umgang mit analogen Geräten vertraut sind, beispielsweise durch den Gebrauch von Rundfunkempfängern, der Eindruck erweckt wird, er benutze ein analoges Funkempfangsgerät. Bei einem analogen Funkempfang ist er mit dessen Eigenschaften vertraut, daß bei einer Verschlechterung der Empfangsbedingungen das Empfangssignal verrauscht ist. Eine solche Person assoziiert ein verrauschtes Empfangssignal im Unterbewußtsein daher sofort mit einer schlechten Empfangslage. Diese Person wird daher dann zielgerichtet solange den eigenen Standort abändern, bis sie einen Standort gefunden hat, bei dem ein unverrauschter Empfang möglich ist.

Wenn die Intensität des Rauschsignals umgekehrt proportional zur Empfangsfeldstärke gesteuert wird, erhält der Benutzer gleichzeitig eine Information über das Ausmaß der Verschlechterung der Empfangsbedingungen. Dies erleichtert vor allem eine Entscheidung darüber, in welche Richtung er sich bei der Ortsveränderung zur Wiederherstellung einer guten Empfangsqualität bewegen muß. Nimmt bei einer Ortsveränderung die Intensität des Rauschsignals zu, so wird es günstig sein, solange die Richtung zu ändern, bis die Intensität des Rauschsignals abnimmt. Vorzugsweise wird das Rauschsignal bei Unterschreitung eines für die Empfangsgüte vorgebbaren Grenzwertes erzeugt.

Dieser Grenzwert wird vorteilhafterweise so gesetzt, daß das Rauschsignal erst bei mäßigen Empfangsgüten einsetzt, bei guten bis sehr guten Empfangsbedingungen jedoch unterdrückt ist. Auf diese Weise erhält der Benutzer nur dann eine Information über die Empfangsgüte, wenn es notwendig wird, darauf zu reagieren. Also in den Fällen, in denen ein Zusammenbruch der Funkverbindung bevorstehen könnte. In anderen Fällen hingegen wird der Empfang jedoch nicht durch das Rauschsignal gestört.

Zur Erzeugung des Rauschsignals eignet sich bei analogen Schaltungskonzepten zum Beispiel die Verstärkung des thermischen Rauschens einer Diode. In digitalen Funkempfängern kann zum Beispiel ein Rauschsignal durch einen digitalen Pseudo-Zufallsgenerator, beispielsweise ein rückgekoppeltes Schieberegister, erzeugt werden. Bei einem digitalen Funkempfänger mit einer Sprachsynthetisierung kann das Rauschsignal aber auch in vorteilhafter Weise durch Änderung von Eingangsparametern des Sprachsynthetisierers erzeugt werden. Dies hat den Vorteil, daß zur Erzeugung des Rauschsignals keine eigens dafür vorgesehene Schaltungsanordnung erforderlich ist.

Im allgemeinen kann die Empfangsgüte durch eine Feldstärkemessung näherungsweise ermittelt werden. Auf eine reine Feldstärkemessung soll jedoch die Erfindung nicht beschränkt sein. Zur Messung der Empfangsgüte eignet sich im besonderen Maße auch die Messung einer Bitfehlerrate oder auch beispielsweise der Signal/Rauschabstand des Empfangssignals oder auch eine Kombination aus solchen Meßergebnissen. Gerade bei dispersiven Übertragungskanälen, wie sie im Mobilfunk auftreten, eignen sich solche Messungen unter Umständen besser als reine Feldstärkemessungen.

Die Erfindung ist jedoch auch nicht darauf beschränkt, daß die Messung der Empfangsfeldstärke in dem Funkempfänger vorgenommen wird, bei dem das Rauschsignal erzeugt wird. Bei Mobilfunksystemen mit Basisstationen und beweglichen Mobilfunkstationen kann die Anordnung zur Messung der Empfangsbedingungen auch in der Basisstation angeordnetsein. Das hat den Vorteil, daß zur Auswertung der Empfangsbedingungen auch aufwendige Methoden verwendet werden können, ohne die Mobilfunkstationen damit zu belasten. Das zur Signalisierung vorgeschlagene Rauschsignal kann durch Signalisierung, z.B. durch Setzen eines Signalisierungsbits in gesendeten Daten, übertragen werden und erst im Mobilfunkgerät synthetisiert werden.

Vorteilhafterweise kann das Rauschsignal aber auch bereits im Sender dem Sprachsignal zugesetzt werden. Dies hat den Vorteil, daß auch herkömmliche Mobilfunkgeräte, bei denen eine solche von den Empfangsbedingungen abhängige Signalerzeugung nicht vorgesehen war, trotzdem das vorgeschlagene Rauschen als Warnsignal erzeugen können.

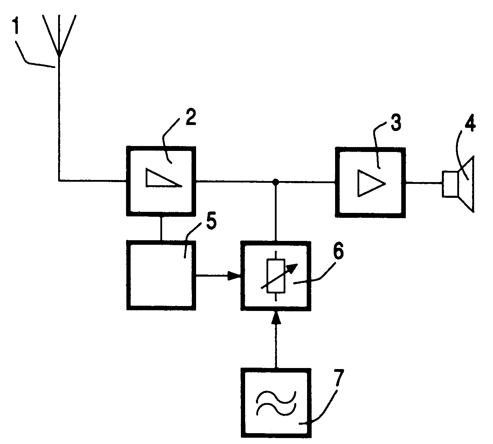

Die Erfindung wird nun anhand eines in der Zeichnung dargestellten Ausführungsbeispiels näher beschrieben und erläutert.

Die einzige Figur zeigt einen Funkempfänger, bei dem ein Empfangssignal über eine Antenne 1 einem Empfangsteil 2 zugeführt ist. Das demodulierte Empfangssignal kann mittels eines NF-Verstärkers 3 über einen Lautsprecher 4 wiedergegeben werden. Ist der Funkempfänger beispielsweise Teil eines Autotelefons, so kann dieser Lautsprecher auch die Hörkapsel eines Bedienhörers oder einer Freisprecheinrichtung sein.

Eine Einrichtung zur Messung 5 einer Bitfehlerrate ermittelt die Bitfehlerrate und steuert in Abhängigkeit der Empfangsfeldstärke die Ausgangsleistung eines Rauschgenerators 7. Die Steuerbarkeit der Ausgangsleistung des Rauschgenerators ist im Ausführungsbeispiel symbolisch durch einen variablen Widerstand 6 dargestellt. Die gesteuerte Ausgangsleistung des Rauschgenerators wird am Eingang des NF-Verstärkers 3 zusätzlich zum Ausgangssignal des Empfangsteils 2 eingespeist und somit dem wiederzugebenden Sprachsignal überlagert.

Solange die Bitfehlerrate unter einem bestimmten Grenzwert liegt (z.B. $10^{-2}$), bei dem eine ausreichende Empfangsqualität sichergestellt ist, ist das Ausgangssignal des Rauschgenerators 7 soweit bedämpft, daß es im wiedergegebenen Sprachsignal nicht hörbar ist. Überschreitet die Bitfehlerrate jedoch diesen vorgegebenen Grenzwert, so tritt im wiedergegebenen Sprachsignal zunehmend das Rauschsignal hervor. Hierbei ist die maximale Ausgangsleistung des Rauschsignals so gewählt, daß ein genügender Nutzsignal/Rauschsignal-Abstand bestehen bleibt, so daß noch eine ausreichende Verständlichkeit des empfangenen Signals gegeben ist. Im Ausführungsbeispiel wird daher die Ausgangsleistung des Rauschgenerators 7 so gewählt, daß sie einen Nutzsignal/Rauschsignal-Abstand von maximal 6 dB erreicht.

**Patentansprüche**

1. Funkempfänger mit einer Anordnung zur Erzeugung eines akustischen Signals,
   dadurch gekennzeichnet,
   daß das akustische Signal ein Rauschsignal ist, das in Abhängigkeit von einer ermittelten Empfangsgüte erzeugt wird.

2. Funkempfänger nach Anspruch 1,
   dadurch gekennzeichnet,
   daß das Rauschsignal erst nach Unterschreiten eines vorgebbaren Grenzwertes der Eingangsgüte erzeugt wird.

3. Funkempfänger nach Anspruch 1 oder 2,
   dadurch gekennzeichnet,
   daß die Intensität des Rauschsignals umgekehrt proportional zur Empfangsgüte gesteuert wird.

4. Funkempfänger nach einem der Ansprüche 1 bis 3,
   dadurch gekennzeichnet,
   daß bei einem digitalen Funkempfänger mit Sprachsynthetisierung das Rauschsignal durch Änderung von Eingangsparametern des Sprachsynthetisierers erzeugt wird.

5. Funkempfänger nach einem der Ansprüche 1 bis 4,
   dadurch gekennzeichnet,
   daß zur Messung der Empfangsgüte eine Bitfehlerrate bestimmt wird.

6. Funkempfänger nach einem der Ansprüche 1 bis 4,
   dadurch gekennzeichnet,
   daß zur Messung der Empfangsgüte der Signal-Rauschabstand eines Eingangssignals bestimmt wird.

7. Funkempfänger nach einem der Ansprüche 1 bis 6,
   dadurch gekennzeichnet,
   daß das akustische Signal in einem dem Funkempfänger zugeordneten Sender initiert wird.